Europäisches Patentamt

European Patent Office

Office européen des brevets

(11) Veröffentlichungsnummer: **0 025 872**
**B1**

(12) **EUROPÄISCHE PATENTSCHRIFT**

(45) Veröffentlichungstag der Patentschrift: **30.10.85**

(51) Int. Cl.⁴: **H 01 L 31/02, H 01 L 31/06**

(21) Anmeldenummer: **80104915.6**

(22) Anmeldetag: **19.08.80**

(54) Halbleiterbauelement für die Umsetzung solarer Strahlung in elektrische Energie.

(30) Priorität: **21.09.79 DE 2938260**

(43) Veröffentlichungstag der Anmeldung:
**01.04.81 Patentblatt 81/13**

(45) Bekanntmachung des Hinweises auf die
Patenterteilung:
**30.10.85 Patentblatt 85/44**

(84) Benannte Vertragsstaaten:
**AT BE CH FR GB IT LI NL**

(56) Entgegenhaltungen:
**GB-A-2 030 766**
**US-A-4 064 521**
**US-A-4 166 919**

**IBM TECHNICAL DISCLOSURE BULLETIN,
Band 21, Nr. 11, April 1979, Seite 4691 New
York, U.S.A. R. TSU et al.: "New type of thin
film hybrid crystalline-amorphous Si solar cell
with high light absorption P-I-N structure"
CHEMICAL ABSTRACTS, Band 77, Br. 8, 21.
August 1972, Seite 384, Nr. 53781b Columbus,
Ohio, U.S.A. O. BUSMUNDRUD et al.: "High
photovoltages in amorphous siliconcrystallin
silicon junctions"**
(73) Patentinhaber: **Messerschmitt-Bölkow-Blohm
Gesellschaft mit beschränkter Haftung
Robert-Koch-Strasse
D-8012 Ottobrunn (DE)**

(72) Erfinder: **Winterling, Gerhard, Dr.
Hermann-Löns-Strasse 16
D-8012 Ottobrunn (DE)**
Erfinder: **Königer, Max, Dr.
Wolfratshauser Strasse 88
D-8023 Pullach (DE)**

Courier Press, Leamington Spa, England.

**Beschreibung**

Die Erfindung betrifft ein Halbleiterbauelement für die Umsetzung solarer Strahlung in elektrische Energie, mit einem amorphen Siliziumkörper und einer Deckschicht aus dotiertem Halbleitermaterial, gemäß dem Oberbegriff des Patentanspruchs 1.

Bei Halbleiterbauelementen der genannten Art hat sich amorphes Silizium (a-Si) in der Herstellung als wesentlich kostengünstigeres Material gegenüber einkristallinem Silizium herausgestellt, siehe hierzu D. E. Carlson and C. R. Wronski; Appl. Phys. Lett. 28, 671, 1976. A-Si wird wegen der erheblich höheren optischen Absorption nur in Schichtdicken von etwa 1 μm gegenüber 50 bis 100 μm bei kristallinem Silizium benötigt, siehe DE-OS 26 32 987, Seite 7. Außerdem kann a-Si direkt aus der Gasphase auf relativ billigen Substraten abgeschieden werden und bedarf im Gegensatz zu kristallinem Silizium keiner aufwendigen weiteren Materialbearbeitungsprozesse. Die Herstellung solcher Halbleiterbauelements ist ausführlich in W. E. Spear et al; Appl. Phys. Lett. 20, 105, 1976 und DE-OS 27 43 141 beschrieben.

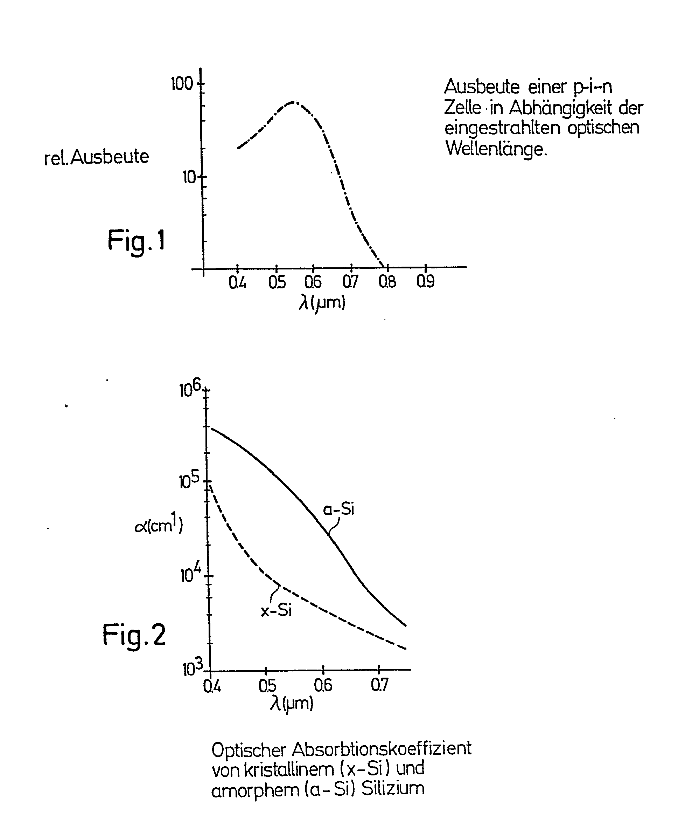

Alle bekannten a-Si-Zellen mit p-i-n- oder p-n-Struktur, die im Gegensatz zu m-i-s-Strukturen eine wesentlich bessere Alterbeständigkeit aufweisen, zeigen ein Absinken der Ausbeute beim Einstrahlung mit blauviolettem Licht, siehe Fig. 1. Diese Tatsache, die auf eine schlechte Konversion des intersiven Blauanteils der Sonnenstrahlung hinweist, trägt mit zu dem gegenüber kristallinem Silizium kleinen Wirkungsgrad der derzeit bekannten a-Si-Zellen bei.

Die schlechte Blauausbeute wird verständlich, wenn man bedenkt, daß der blaue Anteil des Sonnenspektrums nur eine optische Eindringtiefe von kleiner als 0,1 μm im a-Si besitzt. Das blaue Licht wird im wesentlichen in der oberflächennahen a-Si-Kontaktschicht, meistens $p^+$-dotiert mit einer Dicke von ca. 500 Å, absorbiert. Die dort erzeugten Ladungsträger haben wegen der hohen Dotierung und der nahen Oberfläche eine verkürzte Lebensdauer; sie können deshalb kaum zum Diodenübergang gelangen und zum Photostrom beitragen.

Ein Halbleiterbauelement der eingangs genannten Art ist aus IBM Technical Disclosure Bulletin, Band 21, Nr. 11, April 1979, Seite 4691, bekannt. Dort ist eine Dünn-schicht-Solarzelle auf der Basis von Silizium mit p-i-n-Struktur beschrieben, die einen amorphen Siliziumkörper mit auf beiden Seiten befindliche, entgegengesetzt dotierten Deckschichten aus kristallinem Silizium aufweist. Diese Struktur ist auf einem aus Glas oder einem anderweitung transparenten Material bestehenden Substrat aufgebracht, wobei zwischen diesem Substrat und der einen kristallinen Deckschicht eine dünne Aluminiumschicht angeordnet ist. Diese wird von der Substratseite her einer Laserbestrahlung ausgesetzt, um durch Eindiffundieren von Aluminium in die eine Deckschicht in dieser eine p-Dotierung zu erzeugen.

Auf der anderen Seite des amorphen Siliziumkörpers befindet sich eine n-dotierte, ebenfalls unter Laserbestrahlung erzeugte weitere Deckschicht aus kristallinem Silizium. Die äußerst knappe Beschreibung diese bekannten Halbleiterbauelements in der IBM-Druckschrift läßt den Schluß zu, daß die kristallinen Deckschichten vor allem zur Herstellung eines guten ohmschen Kontaktes zu den anschließenden Metallelektroden dienen sollen. Dies und insbesondere die Tatsache, daß eine solche kristalline Deckschicht auch an der dem Lichtenfall abgewandten Seite des amorphen Siliziumkörpers angeordnet ist, deuten darauf hin, daß mit dieser bekannten Struktur jedenfalls nicht die Lösung des Problems beabsichtigt war, eine verbesserte Blauausbeute zu erzielen, wofür ersichtlich nur die strukturellen Verhältnisse auf der Lichteinfallsseite von Bedeutung sein können.

Ein weiteres Halbleiterbauelement der eingangs genannten Art ist aus der US-PS 4 064 521 bekannt. Dieses Halbleiterbauelement weist ebenfalls einen amorphen Siliziumkörper auf, auf dessen dem Lichteinfall zugekehrter Oberfläche eine Deckschicht aus einem Halbleitermaterial mit relativ großer Energielücke, die vorzugsweise breiter als 2,0 eV sein soll, aufgebracht ist. Diese Halbleiter-Deckschicht soll transparent oder semitransparent für einfallende solare Strahlung sein. Als Material für die Halbleiter-Deckschicht ist u.a. monokristallines Silizium genannt, obwohl hier insofern ein gewisser Widerspruch besteht, als dieses eine Energielücke aufweist, deren Breite deutlich unterhalb von 2,0 eV liegt. Der amorphe Siliziumkörper soll durch Glimmentladung in Silan hergestellt werden, die Halbleiter-Deckschicht jedoch auf gänzlich andere Weise. Im Falle einer monokristallinen Silizium-Deckschicht käme ein solches Glimmentladungs-Verfahren auch gar nicht infrage, vielmehr kann hier nur die ebenfalls in der US-PS 4 064 521 gegebene Variante in Betracht kommen, wonach diese Halbleiter-Deckschicht bereits als fertiges Substrat für den mittels Glimmentladung abzuscheidenden amorphen Siliziumkörper dient.

Der Erfindung liegt die Aufgabe zugrunde, ein Halbleiterbauelement der eingangs genannten Art bereitzustellen, das aufgrund einer gesteigerten Blauausbeute einen höheren Wirkungsgrad aufweist, wobei dieses Halbleiterbauelement auf möglichst wirtschaftliche Weise herstellbar sein soll.

Diese Aufgabe wird gemäß der Erfindung dadurch gelöst, daß die Deckschicht eine durch Abscheidung aus einer Silizium enthaltenden Gasphase gewonnene polykristalline Siliziumschicht einer Dicke von höchstens 0,15 μm und einer durch das Abscheidverfahren unmittelbar bedingten mittleren Korngröße ist.

Das polykristalline Silizium weist im Gegensatz zum a-Si eine regelmäßige Anordnung der Silizium-Atome auf, die sich über größere Bereiche erstreckt. Dadurch ist die optische Absorption des sichtbaren Lichts kleiner als im a-Si, insbesondere wird weniger Blau-Licht in der oberflächennahen Silizium-Schicht absorbiert. Die optische Absorption des polykristallinen Siliziums ist näherungsweise gleich der des einkristallinen Siliziums, siehe Fig. 2. Die Lichtabsorption erfolgt daher mehr im Volumen, d.h. im schwach dotierten a-Si, das unter dem polykristallinen Silizium liegt. Zusätzlich haben die Ladungsträger im polykristallinen Silizium eine wesentlich höhere Beweglichkeit als im a-Si; es haben deshalb die Minoritätsträger, die durch die "Rest"-Lichtabsorption in der oberflächennahen Schicht erzeugt werden, eine wesentlich bessere Chance als im a-Si, den Diodenübergang zu erreichen und entsprechend zum Photostrom beizutragen.

Die polykristalline Siliziumschicht soll durch Abscheiden aus einer Silizium enthaltenden Gasphase gewonnen werden. Da auch der amorphe Siliziumkörper durch ein derartiges Verfahren herstellbar ist, liegt hierin eine erhebliche Verbesserung der Wirtschaftlichkeit des gesamten Herstellungsverfahrens. Außerdem ergeben sich durch ein derartiges Abscheideverfahren unmittelbar mittlere Korngrößen innerhalb der polykristallinen Siliziumschicht, die deren Transparenz auch für den blau-violetten Anteil des Spektrums nicht wesentlich beeinträchtigen.

Die Erfindung ist anhand der Figuren näher dargestellt. Es zeigen:

Fig. 3, 4 zwei Strukturen von a-Si-Halbleiterbauelementen mit p-n-Übergängen, mit transparentem Glas als Ausgangssubstrat,

Fig. 5 eine Struktur mit einem Metallsubstrat.

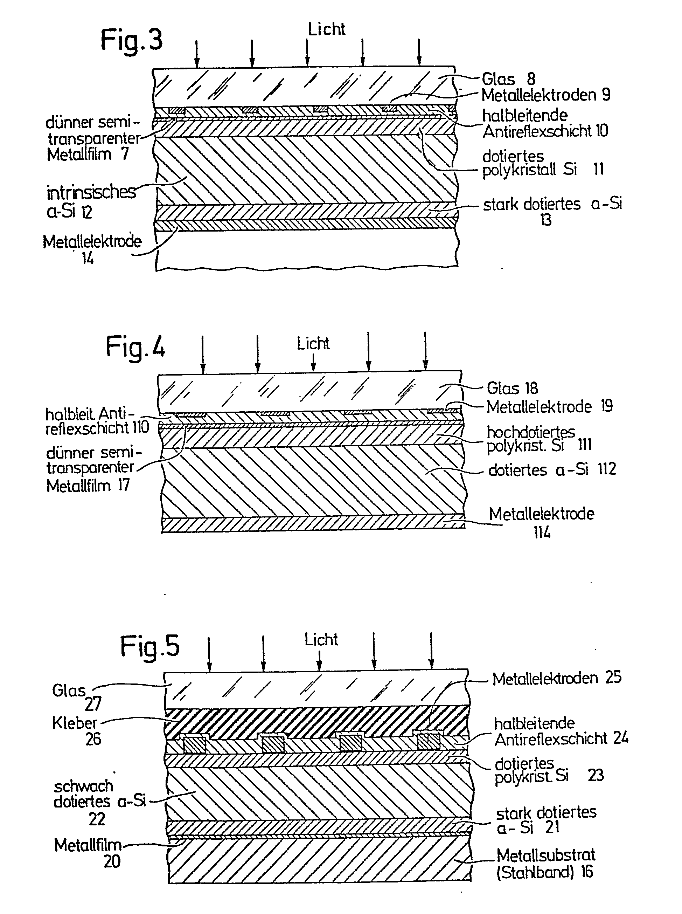

Die in Fig. 3 und 4 dargestellten Strukturen sind in ihrem Aufbau miteinander verwandt, werden jedoch meistens in der Literatur getrennt beschrieben, siehe hierzu auch DE-OS 27 43 141, insbesondere Fig. 3. Bei den gezeigten Strukturen erfolgt die Absorption von sichtbarem Licht der Wellenlänge $\lambda \gtrsim 0,45$ µm hauptsächlich in der a-Si-Schicht 12, 112. Im Falle der p-i-n-Struktur (Fig. 3) ist die Schicht 12 intrinsisch und daher schwach n-leitend. Im Falle der p-n-Struktur (Fig. 4) ist die a-Si-Schicht 112 mit einem Dotierungsprofil versehen, wobei die Dotierung am p-n-Übergang sehr gering ist und erst in der Nähe der Metallelektrode 114 stark ansteigt. Die p-i-n-Struktur kann also als Grenzfall einer p-n-Struktur mit einem speziellen Dotierungsprofil betrachtet werden. Die Schicht 112 kann entweder p- oder n-leitend dotiert sein entsprechend komplementär muß dann die Dotierung der polykristallinen Schicht 111 gewählt werden. Diese besitzt eine höhere Dotierungskonzentration und hat eine Dicke von maximal 0,15 µm. Weiter ist zu beachten, daß bei hoher Dotering die Lebensdauer der Minoritätsträger stark abnimmt. Es sollte sich deshalb die hohe Dotierungskonzentration, die für die Herstellung eine guten ohmschen Kontaktes wichtig ist, auf eine dünne oberflächennahe Schicht beschränken, deren Dicke bei maximal 400 Å liegt.

Die Herstellung der Schichtanordnungen kann auf zwei grundsätzlich unterschiedliche Weisen erfolgen:

A) Als Ausgangssubstrat dient das transparente Glas 8, 18, wie in Fig. 3, 4 dargestellt. Auf dieses Substrat, das Temperaturen bis zu 800°C verträgt und vorzugsweise aus Quarz- oder Vycorglas besteht, wird eine Antireflexschicht 10, 110 aus einem halbleitenden Oxyd abgeschieden. Hierauf folgt eine polykristalline Si-Schicht 11, 111 einer Dicke von maximal 0,15 µm, die durch Abscheiden aus einer Silizium en Halberden Gasphase, z.B. mit Hilfe einer Glimmentladung oder durch thermische Zersetzung von $SiH_4$ oder durch Sputtern auf das heiße Glassubstrat bei Temperaturen T>680°C hergestellt wird.

Bevor weiter die a-Si-Schicht 12, 112 der Dicke von etwa 1 µm aufgebracht wird, erweist es sich im allgemeinen als vorteilhaft, die polykristalline Silizium-Schicht bei einer mittlerem Temperatur von ca, $150°C<T<450°C$ einem Wasserstoffplasma auszusetzen, um verbleibende fluktuierende Bindungen abzusättigen. Die a-Si-Schicht 12, 112 wird bei Substrattemperaturen zwischen 200 und 400°C abgeschieden, beispielsweise durch Zersetzung von $SiH_4$ in einer Glimmentladung oder durch reaktives Sputtern von Si in einer Wasserstoffatmosphäre. Zum Abscheiden der stark dotierten a-Si-Schicht 13 erweist es sich als zweckmäßig, im Falle der Glimmentladung dem Ausgangsgas Dotiergase D ($D=B_2H_6$ oder $AsH_3$, bzw. $PH_3$) im Volumenverhältnis $D/SiH_4$ von $10^{-4}$ bis $5\times10^{-3}$ beizumischen.

Für $D=B_2H_6$ erhält eine p-dotierte, für $D=AsH_3$ oder $PH_3$ eine n-dotierte Schicht. Die Schicht 13 hat in der Regel eine Dicke von etwa 500 Å. Auf diese wird dann die rückseitige, nichttransparente Metallelektrode 14 aufgebracht in der Regel durch Aufdampen der Metallschicht.

Zur Verminderung des Oberflächenwiderstands, d.h. zur besseren Sammlung der photoerzeugten Ladungsträger auf der Lichteinfallsseite, ist es häufig notwendig, eine kammartige Metallelektrode 9, 19 an der Grenzfläche zwischen dem Glassubstrat 8, 18 und der halbleitenden Antireflexschicht 10, 110 vorzusehen.

B) Als Ausgangssubstrat kann auch ein Metallsubstrat 16 eingesetzt werden, siehe Fig. 5. Es wird dann die beschriebene Struktur im umgekehrter Reihenfolge wie bei A) hergestellt. Auf dem Metallsubstrat 16, das vorzugsweise aus einem dünnen Band von Edelstahl besteht und dessen Oberfläche in einer Glimmentladung gereinigt wurde, wird bei einer Temperatur $200°C<T<400°C$, eine stark dotierte a-Si-Schicht 21 der Dicke von etwa 500 Å abgeschieden. Dieser Abscheidungsprozeß wird in der Regel durch eine Glimmentladung oder durch Sputtern erfolgen. Zur besseren Haftung der a-Si-Schicht 21 und zur Erzielung eines guten ohmschen Kontaktes ist es vorteilhaft, einen dünnen Metallfilm 20, vorzugsweise aus Chrom, auf das Metallsubstrat 16 aufzudampfen.

Die eigentliche aktive a-Si-Schicht 22 mit einer Dicke von etwa 1 µm wird ebenfalls bei Substrattemperaturen von ca. $200°C<T<400°C$, vorzugsweise mit den schon oben erwähnten Verfahren, abgeschieden. Für den Fall, daß die a-Si-Schicht 21 stark p-dotiert ist, muß die Schicht 22 schwach p-leitend sein; für den anderen Fall, daß die Schicht 21 stark n-leitend ist, genügt für 22 undotiertes (intrinsisches) a-Si. In beiden Fällen liegt dann der Halbleiterübergang zwischen der Schicht 22 und der hochdotierten polykristallinen Silizium-Schicht 23, die wieder nach dem ober beschriebenen Verfahren aufgebracht wird und eine Dicke von etwa 0,1 µm besitzt.

Auf die polykristalline Silizium-Schicht 23 werden dann kammartige Metallelektroden 25 aufgebracht, die zur Sammlung des Photostromes dienen. Eine halbleitende Antireflexschicht 24, die vorzugsweise die optische Dicke λ/4 besitzt, dient zur Verringerung der Reflexionsverluste. Der Abstand der Metallelektroden 25 ist dabei so eng zu wählen, daß der Oberflächenquerwiderstand der Schichten 23 und 24 einen tolerierbaren Wert nicht übersteigt.

Mit dem Aufbringen der Antireflexschicht 24 ist der Aufbau der "Rohzelle" abgeschlossen. Dem Schutz der empfindlichen Struktur dient eine transparente Kleberschicht 26 in Verbindung mit einer Glasabdeckung 27 oder eine dünne transparente Glasschicht.

## Patentansprüche

1. Halbleiterbauelement für die Umsetzung solarer Strahlung in elektrische Energie, mit einem amorphen Siliziumkörper und einer auf der dem Strahlungseinfall ausgesetzten Oberfläche des amorphen Siliziumkörpers angeordneten Deckschicht aus dotiertem Halbleitermaterial, die mit der relativ niedrig oder entgegengesetzt dotierten oder intrinsischen Oberflächenschicht des amorphen Siliziumkörpers eine Heteroübergang bildet, dadurch gekennzeichnet, daß die Deckschicht eine durch Abscheidung aus einer Silizium enthaltenden Gasphase gewonnene polykristalline Siliziumschicht einer Dicke von höchstens 0,15 µm und einer durch das Abscheideverfahren unmittelbar bedingten mittleren Korngröße ist.

2. Halbleiterbauelement nach Anspruch 1, dadurch gekennzeichnet, daß die polykristalline Siliziumschicht Bestandteil einer folgendermaßen aufgebauten Schichtstruktur ist:

— Schicht (8, 18) aus transparentem Glas
— halbleitende Antireflexschicht (10, 110) mit eingebetteten Metallelektroden(9, 19)
— wahlweise dünner, semitransparenter Metallfilm (7, 17)
— Schicht (11, 111) aus dotiertem polykristallinem Silizium
— Schicht (12), 112) aus schwach dotiertem oder intrinsichem amorphem Silizium
— Schicht (13) aus stark dotiertem amorphem Silizium
— Metallelektrode (14,114).

3. Halbleiterbauelement nach Anspruch 1, dadurch gekennzeichnet, daß die polykristalline Siliziumschicht Bestandteil einer folgendermaßen aufgebauten Schichtstruktur ist:

— Schicht (27) aus transparentem Glas
— Klebeschicht (26)
— halbleitende Antireflexschicht (24) mit eingebetteten Metallelektroden (25)
— Schicht (23) aus dotiertem polykristallinem Silizium
— Schicht (22) aus schwach dotiertem oder intrinsischem amorphem Silizium
— Schicht (21) aus stark dotiertem amorphem Silizium
— wahlweise dünner Metallfilm (20)
— wahlweise Metallsubstrat (16) oder Glas mit Metallfilm.

## Revendications

1. Composant semi-conducteur pour la conversion de rayonnement solaire en énergie électrique comportant un corps de silicium amorphe et, placée sur la surface de ce dernier exposée à l'incidence du rayonnement, une couche de recouvrement en matériau semi-conducteur dopé qui forme avec la couche de surface du corps de silicium amorphe dopée plutôt faiblement ou en polarité contraire ou intrinsèque une hétérojonction, ledit composant semi-conducteur caractérisé par le fait que la couche de recouvrement est une couche de silicium polycristalline obtenue par précipitation à partir d'une phase gazeuse renfermant du silicium en aboutissant à une épaisseur de 0,15 µm au plus et à une grosseur moyenne de grain déterminée directement par le procédé de précipitation.

2. Composant semi-conducteur selon la revendication 1 caractérisé par le fait que la couche de silicium polycristalline est une partie constituante d'une structure stratifiée établie comme suit:

— couche (8, 18) en verre transparent,
— couche antireflet semi-conductrice (10, 110) avec électrodes métalliques (9, 19) noyées,
— facultativement film métallique mince (7, 17) semi-transparent,
— couche (11, 111) en silicium polycristallin dopé,
— couche (12, 112) en silicium amorphe faiblement dopé ou intrinsèque,
— couche (13) en silicium amorphe fortement dopé,
— électrode métallique (14, 114)

3. Composant semi-conducteur selon la revendication 1 caractérisé par le fait que la couche de silicium polycristalline est une partie constituante d'une structure stratifiée établie comme suit:

— couche (27) en verre transparent,
— couche adhésive (26),
— couche antireflet semi-conductrice (24) avec électrodes métalliques (25) noyées,
— couche (23) en silicium polycristallin dopé,

— couche (22) en silicium amorphe faiblement dopé ou intrinsèque,

— couche (21) en silicium amorphe fortement dopé,

— facultativement film métallique mince (20),

— facultativement substrat métallique (16) ou verre avec film métallique.

**Claims**

1. A semiconductor device for the conversion of solar radiation into electrical energy, comprising an amorphous silicon body and a top coating of doped semiconductor material which is arranged on the surface of the amorphous silicon body exposed to incident radiation incidence, and which forms, with the relatively lowly or oppositely doped or intrinsic surface layer of the amorphous silicon body, a heterotransition, characterised in that the top coating consists of a polycrystalline silicon layer, obtained by precipitation from a gas phase which contains silicon, of a thickness of 0.15 µm at the most and an average grain size dictated directly by the precipitation process.

2. A semiconductor component according to claim 1, characterised in that the polycrystalline silicon layer is a constituent part of a stratified structure built up as follows:

— a layer (8, 18) of transparent glass

— a semiconducting antireflective layer (10, 110) with embedded metal electrodes (9, 19)

— a semitransparent metal film (7, 17) which is optionally thin

— a layer (11, 111) of doped polycrystalline silicon

— a layer (12, 112) of weakly doped or intrinsic amorphous silicon

— a layer (13) of strongly doped amorphous silicon

— a metal electrode (14, 114).

3. A semiconductor component according to claim 1, characterised in that the polycrystalline silicon layer is a constituent part of a stratified structure built up as follows:

— a layer (27) of transparent glass

— an adhesive layer (26)

— a semiconducting antireflective layer (24) with embedded metal electrodes (25)

— a layer (23) of doped polycrystalline silicon

— a layer (22) of weakly doped or intrinsic amorphous silicon

— a layer (21) of strongly doped amorphous silicon

— a metal film (20) which is optionally thin

— optionally, a metal substrate (16) or glass with a metal film.

Fig.1

Ausbeute einer p-i-n
Zelle ·in Abhängigkeit der
eingestrahlten optischen
Wellenlänge.

Fig.2

Optischer Absorbtionskoeffizient
von kristallinem (x–Si) und
amorphem (a– Si) Silizium

**Fig.3**

Licht

Glas 8
Metallelektroden 9
halbleitende Antireflexschicht 10
dotiertes polykristall Si 11
stark dotiertes a-Si 13

dünner semi-transparenter Metallfilm 7
intrinsisches a-Si 12
Metallelektrode 14

**Fig.4**

Licht

Glas 18
Metallelektrode 19
hochdotiertes polykrist. Si 111
dotiertes a-Si 112
Metallelektrode 114

halbleit Anti-reflexschicht 110
dünner semi-transparenter Metallfilm 17

**Fig.5**

Licht

Metallelektroden 25
halbleitende Antireflexschicht 24
dotiertes polykrist. Si 23
stark dotiertes a-Si 21
Metallsubstrat (Stahlband) 16

Glas 27
Kleber 26
schwach dotiertes a-Si 22
Metallfilm 20

2